# EUROPEAN PATENT APPLICATION

(11) **EP 4 304 308 A1**
(43) Date of publication of application: **10.01.2024**
(21) Application number: 21928686.1
(22) Date of filing: 27.05.2021
(51) Int. Cl.: H05K 7/14, H02B 1/30, G05B 19/418

(54) **POWER DISTRIBUTION AND MONITORING INTEGRATED ACCESS DOOR**

(30) Priority: 03.03.2021 CN 202120465400 U
(71) Applicant: Vertiv Tech (Xi'An) Co., Ltd., Xi'an, Shaanxi 710005 (CN)
(72) Inventor: NIE, Peng, Shaanxi 710005 (CN); GAO, Cheng, Shaanxi 710005 (CN); LIU, Xin, Shaanxi 710005 (CN); LI, Xing, Shaanxi 710005 (CN)
(74) Representative: Morrall, Jonathan Ian McLachlan
(86) International application number: PCT/CN2021/096246
(87) International publication number: WO 2022/183605

(57) **Abstract**

The present application discloses a power distribution and monitoring integrated access door, comprising: a first door box side cabinet for supplying power to a cabinet, a first compartment and a second compartment for power distribution being provided in the first door box side cabinet; a door lintel fixedly connected to the first door box side cabinet; and a door system used for isolating cold and hot channels, the door system being mounted below the door lintel and disposed on one side of the first door box side cabinet. In the present application, by using the access door of a closed channel as a carrier, power distribution, monitoring, illumination control, access control, and fire control are integrated together. Therefore, in addition to the basic function of isolating the hot and cold channels of the access door, the power distribution and monitoring integrated access door of the present application also has the functions of power distribution, monitoring, illumination control, access control, and fire control.

## Description

The present application claims the priority of the Chinese Patent Application No. 202120465400.5, titled "POWER DISTRIBUTION AND MONITORING INTEGRATED ACCESS DOOR", filed on March 3, 2021 with the China National Intellectual Property Administration, which is incorporated herein by reference in its entirety.

### FIELD

The present application relates to the technical field of large and medium-sized modular data centers, and in particular to a power distribution and monitoring integrated access door.

### BACKGROUND

Large and medium-sized modular data centers generally consist of a server cabinet, an enclosed access (an access door and a skylight), a cooling system, a fire control system, a power distribution system, a monitoring system, a lighting system, and an access control system.

In terms of power distribution, in the current modular data centers, it is generally required to supply power to IT loads through UPS, and supply power to a refrigeration system through utility power. Conventionally, it can be achieved by UPS and a power distribution cabinet or an integrated UPS power distribution cabinet. However, both of these solutions have their own shortcomings that cannot be solved. With the solution of UPS and the power distribution cabinet, two positions for a server cabinet need to be occupied when arranging the UPS and a power distribution cabinet in the modular data center, resulting in significant reduction in the installed capacity of IT loads in the entire modular data center. With the solution of the integrated UPS power distribution cabinet, the occupation of one position for a cabinet can be reduced. However, due to the limitation of cabinet space, it is limited to N+1 system. Since it is difficult for a single integrated UPS power distribution cabinet to meet the requirements of 2N power supply and distribution system, for the 2N system, it still needs two integrated UPS power distribution cabinets, thereby still occupying two positions for a server cabinet. In order to reduce the occupation of a position for a cabinet, some manufacturers use an intelligent bus system to supply power to the IT loads. However, due to the limitation of bus, additional power distribution boxes are still needed to supply power to a cooling system, a lighting system and other systems. Therefore, with any of the above solutions, more space are occupied, resulting in a large number of cable connections, which not only occupies the installation space of IT equipment of a customer, but also increases the workload of power distribution for cables in the construction.

In terms of monitoring, lighting and access control, in order to realize these functions, different controllers or control boxes, such as a monitoring control box, a lighting controller and an access control controller, are usually configured for the functions. Some of these devices need to be mounted in the server cabinet, and some need to be placed freely at a top of the server cabinet. The devices, being mounted in the cabinet, further occupy U-bit space of IT load of a customer, and the devices being mounted on the top of the cabinet are not convenient for construction and operation and the devices cannot be fixed easily, which affects the overall anti-vibration performance. In addition, these control devices usually have weak electricity circuits, and thus no matter where the control devices are mounted, they either occupy some space in a weak electricity wire slot of a customer or are difficult to be laid separately from strong electricity lines. Even if a specific wiring route is designed, it is required to be laid on site, and the construction quality is difficult to control.

### SUMMARY

In order to solve the above problems, a power distribution and monitoring integrated access door is provided according to the present application. The access door for closing a channel is used as a carrier, and a power distribution system, a monitoring system, a lighting control system, an access control system and even a fire control system are integrated, thereby releasing the occupied U-bit space in a modular data center for IT equipment installation, which can be referred to a true OU design of power distribution, access control, monitoring and lighting.

In order to solve the above technical problems, the following technical solutions are provided according to the present application.

A power distribution and monitoring integrated access door includes:
a first door box side cabinet for supplying power to a cabinet, where a first compartment and a second compartment for accommodating power distribution components are provided in the first door box side cabinet, and the first compartment and the second compartment each is in a shape of cavity;
a door lintel fixedly connected to the first door box side cabinet;
a door system configured to isolate cold and hot channels, where the door system is mounted below the door lintel and arranged on one side of the first door box side cabinet.

Further, the power distribution and monitoring integrated access door further includes: a heat dissipation air passage for dissipating heat for the first compartment and/or the second compartment.

Further, the heat dissipation air passage includes a first air inlet, a first air outlet and a first air guide cavity. The first air inlet is provided at one side, where one of the first compartment and the second compartment is located, of the first door box side cabinet, and the first air outlet is provided at one side, where the other of the first compartment and the second compartment is located, of the first door box side cabinet. One end of the first air guide cavity is connected to a first air inlet, and the other end of the first air guide cavity is connected to the other of the first compartment and the second compartment.

Further, the power distribution and monitoring integrated access door further includes a first protective plate and a second protective plate. The first protective plate and the second protective plate are overlapped with each other and covered on one of the first compartment and the second compartment. The second protective plate is also covered on the other of the first compartment and the second compartment.

Further, one or more of a UPS power distribution circuit, a matched monitoring sensor and a power distribution protection device are mounted in the first compartment.

Further, the first door box side cabinet is provided with a first quick connection port for connecting the first door box side cabinet with the cabinet.

Further, the power distribution and monitoring integrated access door further includes a second door box side cabinet which is connected with the door lintel and arranged on the other side of the door system,the second door box side cabinet includes a third compartment and a fourth compartment which are in a shape of cavity, and the fourth compartment and the third compartment are arranged on the other side of the door system in a mirroring manner with the first compartment and the second compartment, respectively.

Further, the power distribution and monitoring integrated access door further includes a heat dissipation air passage for dissipating heat for the third compartment and/or the fourth compartment.

Further, the power distribution and monitoring integrated access door further includes a second air inlet, a second air outlet and a second air guide cavity. The second air inlet is provided at one side, where one of the third compartment and the fourth compartment is located, of the second door box side cabinet, and the second air outlet is provided at one side, where the other of the third compartment and the fourth compartment is located, of the second door box side cabinet. One end of the second air guide cavity is connected to the second air inlet, and the other end of the second air guide cavity is connected to the other of the third compartment and the fourth compartment.

Further, the power distribution and monitoring integrated access door further includes a third protective plate and a fourth protective plate. The third protective plate and the fourth protective plate are overlapped with each other and covered on one of the third compartment and the fourth compartment. The fourth protective plate is also covered on the other of the third compartment and the fourth compartment.

Further, the second door box side cabinet is provided with a second quick connection port for connecting the second door box side cabinet with the cabinet.

Further a monitoring control box and an access control controller are integrated in the fourth compartment.

Further, a cable for connecting the first door box side cabinet with the second door box side cabinet is arranged in the door lintel.

Further, the power distribution and monitoring integrated access door further includes a user cross-channel wire slot. The user cross-channel wire slot is arranged above the door lintel, and a cable for connecting different cabinets is arranged inside the user cross-channel wire slot.

The following beneficial effects can be realized by the present application.

In the present application, the access door for closing a channel is used as a carrier on which a power distribution system, a monitoring system, a lighting control system, an access control system and a fire control system are all integrated. Therefore, in addition to the basic function of isolating the hot and cold channels of the access door, the power distribution and monitoring integrated access door according to the present application also has the functions of power distribution, monitoring, lighting control, access control, and fire control.

### BRIEF DESCRIPTION OF THE DRAWINGS

FIG. 1 is a front view of a power distribution and monitoring integrated access door according to a preferred embodiment of the present application;
FIG. 2 is an exploded view of a first door box side cabinet according to a preferred embodiment of the present application;
FIG. 3 is a schematic view showing the three-dimensional structure of a back side of a power distribution and monitoring integrated access door according to a preferred embodiment of the present application;
FIG. 4 is an exploded view of a second door box side cabinet according to a preferred embodiment of the present application;
FIG. 5 is a schematic view showing the three-dimensional structure of a door lintel according to a preferred embodiment of the present application.

### Reference numerals include:

| | | | |
|---|---|---|---|
| 1 | -first door box side cabinet; | 11 | -first compartment; |
| 12 | -second compartment; | 13 | -first air inlet; |
| 14 | -first air guide cavity; | 15 | -first air outlet; |
| 16 | -first protective plate; | 17 | -second protective plate; |
| 18 | -first quick connection port; | 2 | -second door box side cabinet; |
| 21 | -third compartment; | 22 | -fourth compartment; |
| 221 | -monitoring control box; | 222 | -access control controller; |
| 23 | -second air inlet; | 24 | -second air guide cavity; |
| 25 | -second air outlet; | 26 | -third protective plate; |
| 27 | -fourth protective plate; | 28 | -second quick connection port; |
| 3 | -door lintel; | 31 | -lighting control sensor; |
| 4 | -door system; | 5 | -user cross-channel wire slot. |

### DETAILED DESCRIPTION OF THE EMBODIMENTS

In order to make the technical problems to be solved by the present application, and technical solutions, beneficial effects of the present application clearer, the present application will be further described in detail in conjunction with the accompanying drawings and embodiments. It can be understood that the embodiments described herein are only used to illustrate the present application, rather than constituting a limitation to the embodiment.

It should be noted that, if an element is referred to as being "fixed to" or "arranged on" another element, the former element can be directly on the latter element, or indirectly on the latter element. If an element is referred to as being "connected" to another element, the former element can be directly connected to the latter element, or indirectly connected to the latter element.

It should be noted that the orientation or positional relationship indicated by the terms, such as "length", "width", "upper", "lower", "front", "rear", "left", "right", "vertical", "horizontal", "top", "bottom", "inner", and "outer", are based on the orientation or positional relationship shown in the drawings, which are only used to facilitate the description of the present application and to simplify the description, rather than indicating or implying that the device or element referred to must have a specific orientation, or can only be configured and operated in a particular orientation. Therefore, the above terms should not be construed as a limitation to the present application.

In addition, terms "first" and "second" are only used for description and should not be construed as indicating or implying relative importance, or as specifying a quantity of indicated technical features implicitly. Therefore, the features defined by "first" and "second" may explicitly or implicitly include one or more of the features. In the description of the present application, unless otherwise specifically limited, the term "multiple" means two or more.

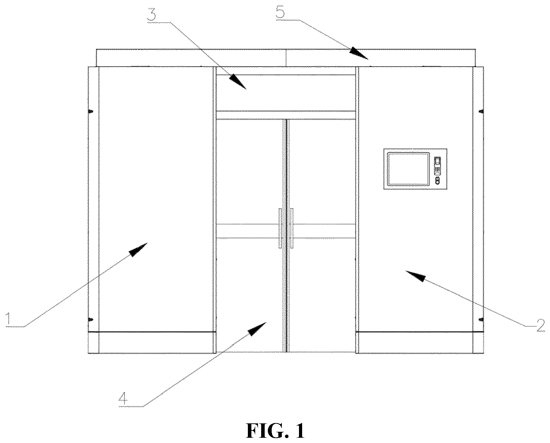

With reference to FIG. 1 to FIG. 5, a power distribution and monitoring integrated access door according to a preferred embodiment of the present application includes: a first door box side cabinet 1 for supplying power to a cabinet, where a first compartment 11 and a second compartment 12 for accommodating power distribution components are provided in the first door box side cabinet 1, and the first compartment 11 and the second compartment 12 each is in a form of cavity; a door lintel 3 fixedly connected to the first door box side cabinet 1; and a door system 4 configured to isolate cold and hot channels, where the door system 4 is mounted below the door lintel 3 and slidably provided in the second compartment 12 and in the door lintel 3.

In the present application, the access door for closing a channel is used as a carrier on which a power distribution system, a monitoring system, a lighting control system, an access control system and a fire control system are all integrated. Therefore, in addition to the basic function of isolating the hot and cold channels of the access door, the power distribution and monitoring integrated access door according to the present application also has the functions of power distribution, monitoring, lighting control, access control, and fire control. Every part of the power distribution and monitoring integrated access door will be described in detail below.

As shown in FIG. 1, in a preferred embodiment of the present application, the power distribution and monitoring integrated access door mainly includes a first door box side cabinet 1, a second door box side cabinet 2, a door lintel 3 and a door system 4. In another embodiment of the present application, the second door box side cabinet 2 may be eliminated, so that the power distribution and monitoring integrated access door can be adapted to an application scenario in which a single-row cabinet arranged against a wall is configured to close a channel. That is, in this embodiment, the power distribution and monitoring integrated access door only includes the first door box side cabinet 1, the door lintel 3 and the door system 4. Or the second door box side cabinet 2 is placed at a position away from the first door box side cabinet 1, and the power distribution and monitoring integrated access door can also be adapted to the application scenario in which a single-row cabinet arranged against a wall is configured to close a channel.

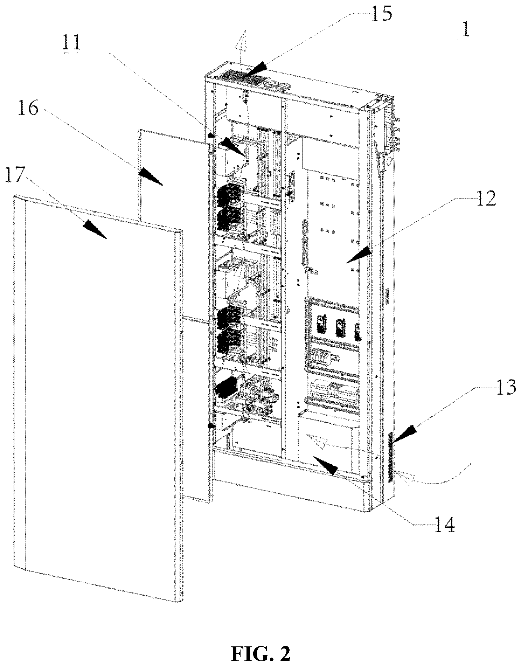

As shown in FIG. 2, a UPS power distribution circuit, a matched monitoring sensor and a power distribution protection device are mounted in a cavity of the first door box side cabinet 1. The core function of the first door box side cabinet 1 is to supply power to an IT cabinet, which can realize UPS dual power distribution for the system, and independent power distribution for left and right row cabinets in a data center, that is, can realize IT load dual power distribution only for the single-row cabinet. Therefore, it can be adapted to the scenario of small IT load in the initial use of the data center, and provide a more efficient and energy-saving power distribution solution for customers.

As shown in FIG. 2, the first door box side cabinet 1 is configured to be divided into a first compartment 11 and a second compartment 12 based on a multi-compartment design. The first compartment 11 and the second compartment 12 are cavities of which the interiors are used to accommodate various components. The first compartment 11 is mainly configured for installing a strong electricity part of UPS power distribution, and the second compartment 12 is configured for a weak electricity part of power distribution monitoring and a moving part of the door system 4.

Preferably, in terms of the characteristic of multi-compartment, the first door box side cabinet 1 further includes a heat dissipation air passage, which includes a first air inlet 13, a first air outlet 15 and a first air guide cavity 14. One end of the first air guide cavity 14 is connected to the first air inlet 13 and the other end is connected to the first compartment 11. The first air inlet 13 is provided at the lower half, where the second compartment 12 is located, of the first door box side cabinet 1, to firstly introduce cold air into the second compartment 12 of the first door box side cabinet 1. The first air inlet 13 is preferably in a form of air inlet honeycomb holes. Then, the cold air is introduced through the air guide cavity 14 into the first compartment 11 in which a large amount of heat generation exists. The first air outlet 15 is provided at a top, where the first compartment 11 is located, of the first door box side cabinet 1, so that hot air can be discharged from the first compartment 11 of the first door box side cabinet 1 by using the chimney effect produced by the cavity of the first compartment 11. Preferably, the first air outlet 15 is in a form of heat dissipation mesh holes.

In a preferred embodiment of the present application, the power distribution and monitoring integrated access door further includes a first protective plate 16 and a second protective plate 17. The first protective plate 16 and the second protective plate 17 is overlapped with each other and covered on the first compartment 11. By designing a double-layer protective cover structure for the first compartment 11, the safety of on-site construction, commissioning and later maintenance may be improved. In addition, the second protective plate 17 is also covered on the second compartment 12.

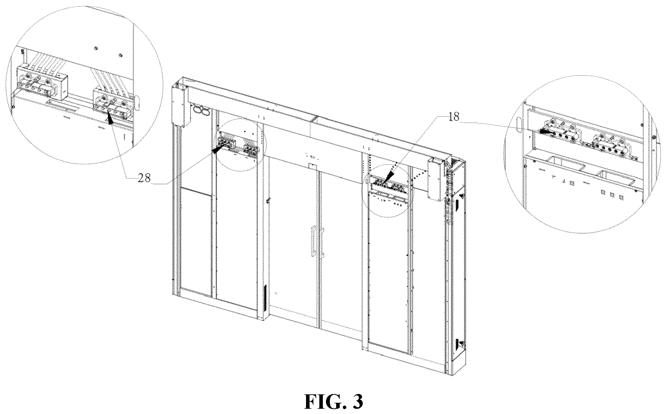

As shown in FIG. 3, the first door box side cabinet 1 is provided with a first quick connection port 18 for connecting the first door box side cabinet 1 with the cabinet, to achieve wireless connection to the UPS power distribution and monitoring of a back-end IT cabinet. A power distribution circuit and a monitoring circuit are integrated through the first quick connection port 18, to cooperate with the intelligent IT cabinet having a flexible bus-bar system and a distributed monitoring and controlling unit, there is no need to lay cables for the power distribution and monitoring of the IT cabinet, which significantly reduces the workload and difficulty of the construction on site, realizing a plug-and-play connection and one-button networking.

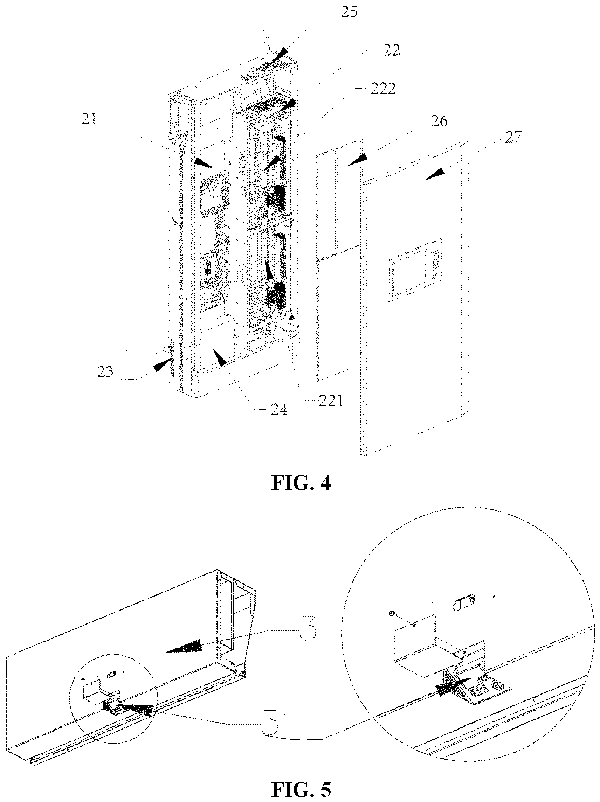

As shown in FIG. 4, the second door box side cabinet 2 includes a utility power distribution circuit, a monitoring control box, a monitoring interactive interface, an access control controller, and a fire control access port. The core function of the second door box side cabinet 2 is to provide utility power distribution to an air conditioning cabinet, centralized monitoring of the data center, and access control management. Dual utility power supply for air conditioners can be realized through the power distribution, which can support individual dual power supply for each of the air conditioners in a case of small IT loads.

The interior of the second door box side cabinet 2 is also configured to be divided into multiple compartments, including a third compartment 21 and a fourth compartment 22, each of which is in a shape of cavity and used to accommodate various components in the interior. The fourth compartment 22 and the third compartment 21 are arranged on the other side of the door system 4 in a mirroring manner with the first compartment 11 and the second compartment 12, respectively. A utility power distribution circuit, a monitoring control box, and an access control controller are mounted inside the fourth compartment 22, and the third compartment 21 is configured for the utility power distribution monitoring and a moving part of the door system 4.

A monitoring control box 221 and an access control controller 222 are integrated in the fourth compartment 22. Considering the problem of strong electricity and weak electricity isolation, specific slots are designed for these two parts respectively, and physical separation is realized by side baffles.

Similar to the first compartment 11, the fourth compartment 22 is also of a double-layer protection structure. That is, the power distribution and monitoring integrated access door further includes a third protective plate 26 and a fourth protective plate 27, which are overlapped with each other and covered on the fourth compartment 22. The fourth protective plate 27 is also covered on the third compartment 21.

Similar to the first door box side cabinet 1, the second door box side cabinet 2 also includes a heat dissipation air passage. The heat dissipation air passage includes a second air inlet 23, a second air outlet 25 and a second air guide cavity 24. One end of the second air guide cavity 24 is connected to the second air inlet 23, and the other end is connected to the fourth compartment 22. The second air inlet 23 is provided at the lower half, where the third compartment 21 is located, of the second door box side cabinet 2, to firstly introduce cold air into the third compartment 21 of the second door box side cabinet 2. The second air inlet 23 is preferably in a form of air inlet honeycomb holes. Then, the cold air is introduced through the air guide cavity 24 into the fourth compartment 22 in which a large amount of heat generation exists. The second air outlet 25 is provided at the top of, where the fourth compartment 22 is located, of the second door box side cabinet 2, so that hot air can be exhausted from the fourth compartment 22 of the second door box side cabinet 2 by using the chimney effect produced by the cavity of the fourth compartment 22. Preferably, the second air outlet 25 is in a form of heat dissipation mesh holes.

In addition, as shown in FIG. 3, the second door box side cabinet 2 further includes a second quick connection port 28 for UPS power distribution. The second quick connection port 28 is an extension section of the power supply from the first door box side cabinet 1 to the IT cabinet adjacent to the second door box side cabinet 2, and has independent routing and protection measures.

A cable for connecting the first door box side cabinet 1 with the second door box side cabinet 2 is arranged in the door lintel 3. The door lintel 3 provides cross-channel routing for the power distribution and monitoring of the first door box side cabinet 1 and the second door box side cabinet 2, and provides structural support for the door system 4. As shown in FIG. 5, a lighting control sensor 31 is integrated in the door lintel 3, which realizes the automatic control of lighting with lights on when people come and lights off when people leave.

The door system 4 is a core component, used for isolating cold and hot channels, of the integrated access door, and is preferably an automatic door system, which can cooperate with the access control controller and a fire control port. When the access control or fire control is triggered, the automatic door system may complete set actions such as opening and closing the door, and holding the door open, in response to the triggering. Of course, it can be understood that, alternatively, the automatic door system may be replaced with a mechanical semi-automatic door system.

As shown in FIG. 1, the power distribution and monitoring integrated access door further includes a user cross-channel wire slot 5. The user cross-channel wire slot 5 is arranged above the door lintel 3, and a cable for connecting different cabinets arranged inside the user cross-channel wire slot 5.

In the present application, the access door for closing a channel is used as a carrier on which a power distribution system, a monitoring system, a lighting control system, an access control system and a fire control system are all integrated. Therefore, in addition to the basic function of isolating the hot and cold channels of the access door, the power distribution and monitoring integrated access door according to the present application also has the functions of power distribution, monitoring, lighting control, access control, and fire control.

The above content is only the preferred embodiments of the present application. Various variations can be made by those skilled in the art in terms of embodiments and application scope according to ideas of the present application, and fall within the protection scope of the present application without departing from the concept of the present application.

## Claims

1. A power distribution and monitoring integrated access door, **characterized in that** the power distribution and monitoring integrated access door comprises:
a first door box side cabinet (1) for supplying power to a cabinet, wherein a first compartment (11) and a second compartment (12) for accommodating power distribution components are provided in the first door box side cabinet (1), and the first compartment (11) and the second compartment (12) are in a shape of cavity;
a door lintel (3) fixedly connected to the first door box side cabinet (1);
a door system (4) configured to isolate cold and hot channels, wherein the door system (4) is mounted below the door lintel (3) and arranged on one side of the first door box side cabinet (1).

2. The power distribution and monitoring integrated access door according to claim 1, **characterized in that** the power distribution and monitoring integrated access door further comprises: a heat dissipation air passage for dissipating heat for the first compartment (11) and/or the second compartment (12).

3. The power distribution and monitoring integrated access door according to claim 2, **characterized in that** the heat dissipation air passage comprises a first air inlet (13), a first air outlet (15) and a first air guide cavity (14), the first air inlet (13) is provided at one side, where one of the first compartment and the second compartment is located, of the first door box side cabinet (1), and the first air outlet (15) is provided at one side, where the other of the first compartment and the second compartment is located, of the first door box side cabinet (1); and one end of the first air guide cavity (14) is connected to the first air inlet (13), and the other end of the first air guide cavity (14) is connected to the other of the first compartment and the second compartment.

4. The power distribution and monitoring integrated access door according to claim 1, **characterized in that** the power distribution and monitoring integrated access door further comprises a first protective plate (16) and a second protective plate (17), the first protective plate (16) and the second protective plate (17) are overlapped with each other and covered on one of the first compartment and the second compartment; and the second protective plate (17) is also covered on the other of the first compartment and the second compartment.

5. The power distribution and monitoring integrated access door according to claim 1, **characterized in that** one or more of a UPS power distribution circuit, a matched monitoring sensor and a power distribution protection device are mounted in the first compartment (11).

6. The power distribution and monitoring integrated access door according to claim 1, **characterized in that** the first door box side cabinet (1) is provided with a first quick connection port (18) for connecting the first door box side cabinet (1) with the cabinet.

7. The power distribution and monitoring integrated access door according to claim 1, **characterized in that** the power distribution and monitoring integrated access door further comprises a second door box side cabinet (2) which is connected with the door lintel (3) and arranged on the other side of the door system (4), the second door box side cabinet (2) comprising a third compartment (21) and a fourth compartment (22) which are in a shape of cavity, and the fourth compartment (22) and the third compartment (21) are arranged on the other side of the door system (4) in a mirroring manner with the first compartment (11) and the second compartment (12), respectively.

8. The power distribution and monitoring integrated access door according to claim 7, **characterized in that** the power distribution and monitoring integrated access door further comprises: a heat dissipation air passage for dissipating heat for the third compartment (21) and/or the fourth compartment (22).

9. The power distribution and monitoring integrated access door according to claim 8, **characterized in that** the power distribution and monitoring integrated access door further comprises a second air inlet (23), a second air outlet (25) and a second air guide cavity (24), the second air inlet (23) is provided at one side, where one of the third compartment and the fourth compartment is located, of the second door box side cabinet (2), and the second air outlet (25) is provided at one side, where the other of the third compartment and the fourth compartment is located, of the second door box side cabinet (2); and one end of the second air guide cavity (24) is connected to the second air inlet (23), and the other end of the second air guide cavity (24) is connected to the other of the third compartment and the fourth compartment.

10. The power distribution and monitoring integrated access door according to claim 7, **characterized in that** the power distribution and monitoring integrated access door further comprises a third protective plate (26) and a fourth protective plate (27), the third protective plate (26) and the fourth protective plate (27) are overlapped with each other and covered on one of the third compartment and the fourth compartment; and the fourth protective plate (27) is also covered on the other of the third compartment and the fourth compartment.

11. The power distribution and monitoring integrated access door according to claim 7, **characterized in that** the second door box side cabinet (2) is provided with a second quick connection port (28) for connecting the second door box side cabinet (2) with the cabinet.

12. The power distribution and monitoring integrated access door according to claim 7, **characterized in that** a monitoring control box (221) and an access control controller (222) are integrated in the fourth compartment (22).

13. The power distribution and monitoring integrated access door according to claim 7, **characterized in that** a cable for connecting the first door box side cabinet (1) with the second door box side cabinet (2) is arranged in the door lintel (3).

14. The power distribution and monitoring integrated access door according to any one of claims 1 to 13, **characterized in that** the power distribution and monitoring integrated access door further comprises a user cross-channel wire slot (5), the user cross-channel wire slot (5) is arranged above the door lintel (3), and a cable for connecting different cabinets is arranged inside the user cross-channel wire slot (5).
